Europäisches Patentamt

European Patent Office

Office européen des brevets

(11) Veröffentlichungsnummer: **0 362 493 B1**

# EUROPÄISCHE PATENTSCHRIFT

(45) Veröffentlichungstag der Patentschrift: **20.10.93**

(21) Anmeldenummer: **89112619.5**

(22) Anmeldetag: **11.07.89**

(51) Int. Cl.⁵: **H01L 43/06**, H01L 27/22

(54) **Hallelement.**

(30) Priorität: **21.09.88 CH 3512/88**

(43) Veröffentlichungstag der Anmeldung:
**11.04.90 Patentblatt 90/15**

(45) Bekanntmachung des Hinweises auf die
Patenterteilung:
**20.10.93 Patentblatt 93/42**

(84) Benannte Vertragsstaaten:
**AT CH DE ES FR GB GR IT LI**

(56) Entgegenhaltungen:
**EP-A- 0 148 330**
**US-A- 4 123 772**

**PROCEEDINGS OF THE IEEE, Band 74, Nr. 8,
August 1986, Seiten 1107-1132, IEEE, New
York, US; H.P. BALTES et al.: "Integrated semiconductor magnetic field sensors"**

(73) Patentinhaber: **Landis & Gyr Business Support AG**

**CH-6301 Zug(CH)**

(72) Erfinder: **Urs, Falk**
**Sinserstrasse 19**
**CH-6330 Cham(CH)**
Erfinder: **Radivoje, Popovic**
**Fridbach 1**
**CH-6300 Zug(CH)**

**Beschreibung**

Die Erfindung bezieht sich auf ein Hallelement gemäss dem Oberbegriff des Anspruchs 1.

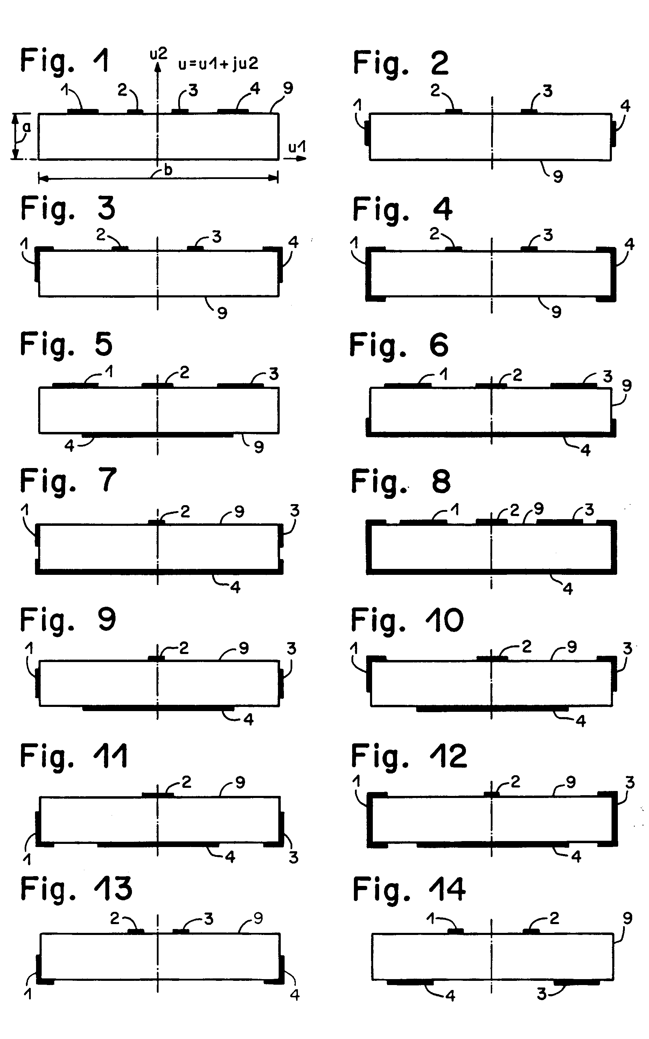

Hallelemente dieser Art sind bekannt aus der Druckschrift "Proceedings of the IEEE", Vol. 74, No 8, August 1986, Seiten 1107 bis 1131, "Integrated Semiconductor Magnetic Field Sensors", H. P. Baltes and R. S. Popovic, Fig. 3, bei denen die Elektroden räumlich punktsymmetrisch zum Mittelpunkt des Hallelementes angeordnet sind, damit das Hallelement auch elektrisch symmetrisch arbeitet, so dass dessen Nullspannung ("Offset"-Spannung) theoretich immer gleich Null ist.

Bekannt aus der EP-A-0 148 330 sind integrierte Hallelemente, deren gleichgrosse Elektroden räumlich symmetrisch auf einer geraden Linie an der Oberfläche des integrierten Hallelementes angeordnet sind.

Der Erfindung liegt die Aufgabe zugrunde, ein Hallelement der eingangs genannten Art derartig abzuändern, dass trotz einer räumlich punktunsymmetrischen Anordnung der Elektroden zum Mittelpunkt des Hallelementes die elektrisch symmetrische Arbeitsweise dieses Hallelementes erhalten bleibt. Durch die punktunsymmetrische Anordnung der Elektroden ist es möglich, Hallelemente zu realisieren, die einfach in einer integrierten Schaltung integrierbar sind, da z. B. alle Elektroden in diesem Fall auf einer einzigen Seite des Hallelementes angeordnet sind, die dann der Oberfläche der integrierten Schaltung entspricht.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den Unteransprüchen.

Ausführungsbeispiele der Erfindung sind in der Zeichnung dargestellt und werden im folgenden näher beschrieben.

Es zeigen:

Fig. 1 bis Fig. 47      je einen Querschnitt verschiedener Varianten eines erfindungsgemässen Hallelementes,

Fig. 48      eine Darstellung in einer w-Ebene einer Variante von Querschnittsanordnungen fiktiver Elektroden,

Fig. 49      eine mathematisch konforme Abbildung in einer z-Ebene der in der Fig. 48 dargestellten Variante von Querschnittsanordnungen fiktiver Elektroden,

Fig. 50      eine mathematisch konforme Abbildung in einer v-Ebene der in der Fig. 49 dargestellten Variante von Querschnittsanordnungen fiktiver Elektroden,

Fig. 51      eine Darstellung in der w-Ebene einer weiteren Variante von Querschnittsanordnungen fiktiver Elektroden,

Fig. 52      einen Querschnitt der weiteren Variante des erfindungssgemässen Hallelementes und

Fig. 53      einen Querschnitt eines integrierten erfindungsgemässen Hallelementes.

Gleiche Bezugszahlen bezeichnen in allen Figuren der Zeichnung gleiche Teile.

Das erfindungsgemässe Hallelement besitzt eine Vielzahl von Elektroden, deren Anzahl ein Multipel von vier ist und die jeweils Vierergruppen bilden. In jeder Vierergruppe von Elektroden sind jeweils eine erste und eine zweite Stromelektrode sowie eine erste und eine zweite Sensorelektrode vorhanden. Beim Vorhandensein mehrerer Vierergruppen sind in der Regel die gleichnamigen Elektroden aller Vierergruppen ausserhalb des Hallelementes elektrisch parallel geschaltet.

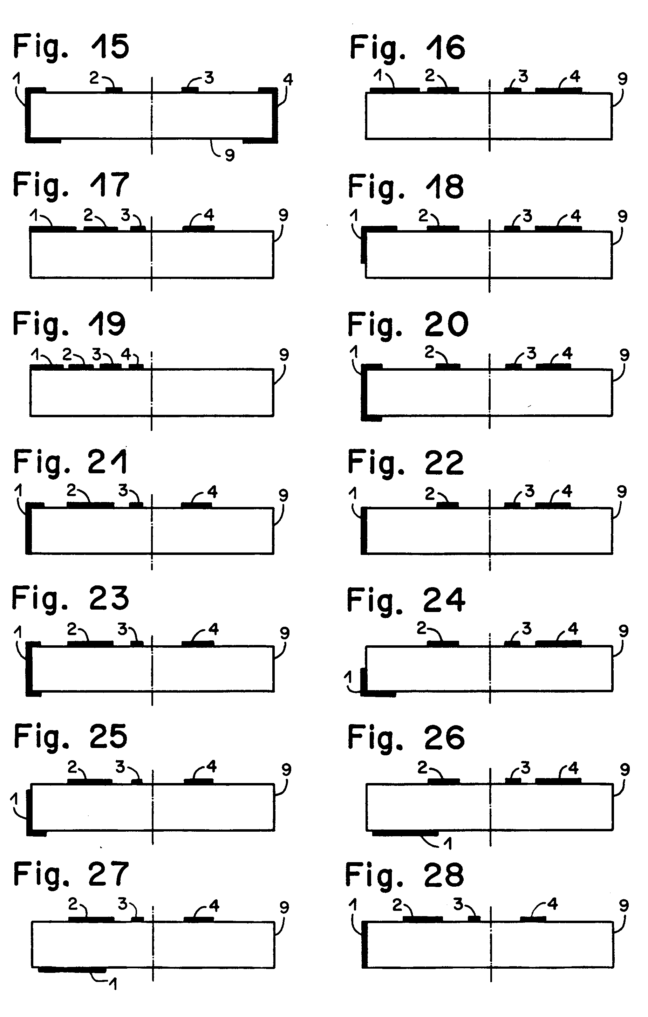

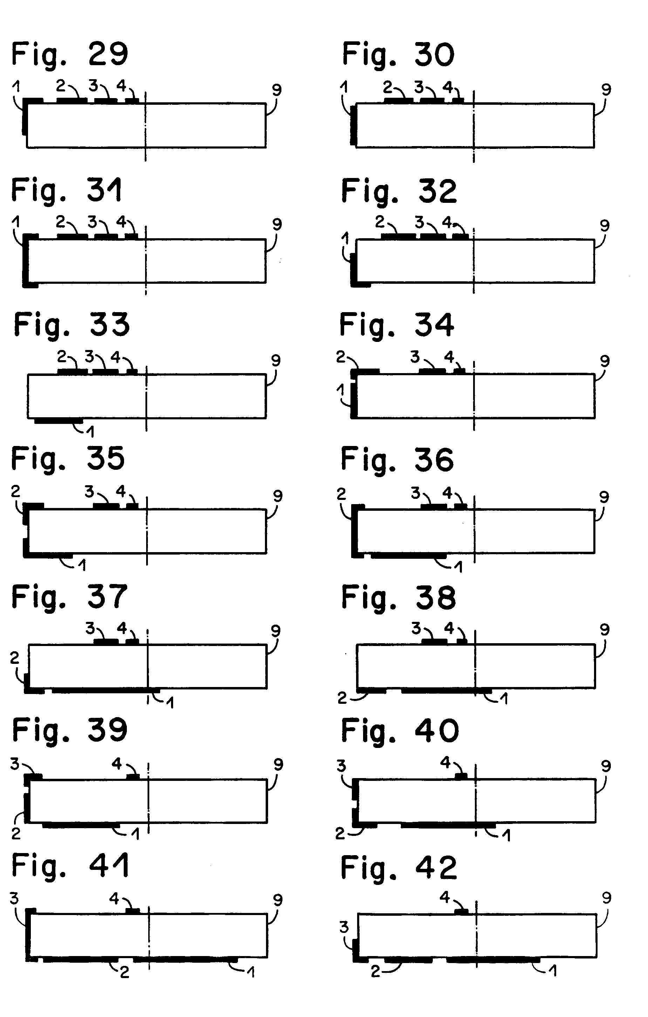

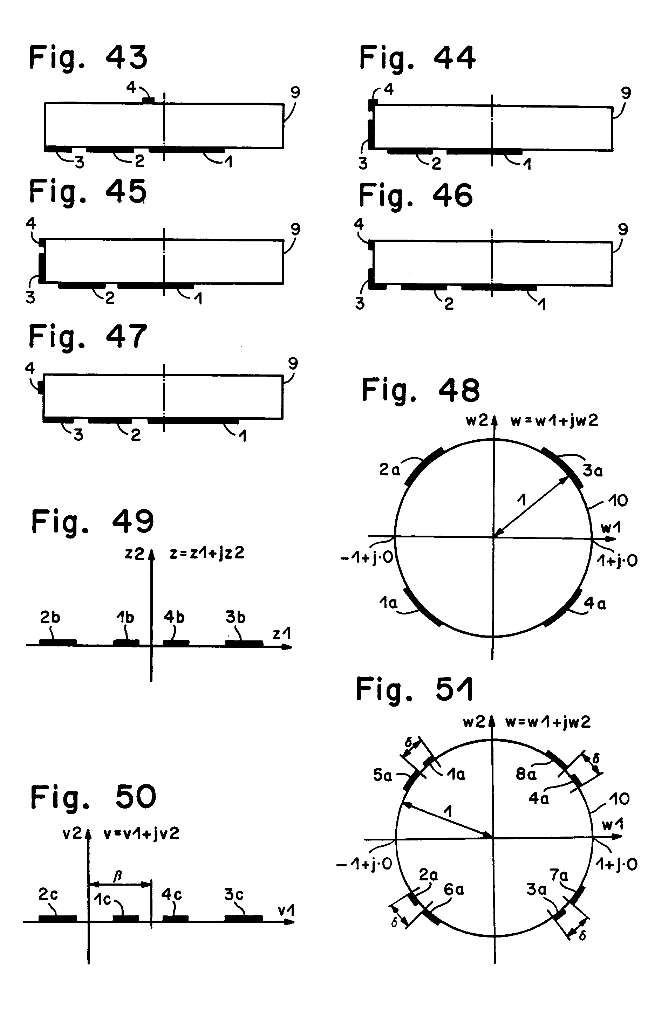

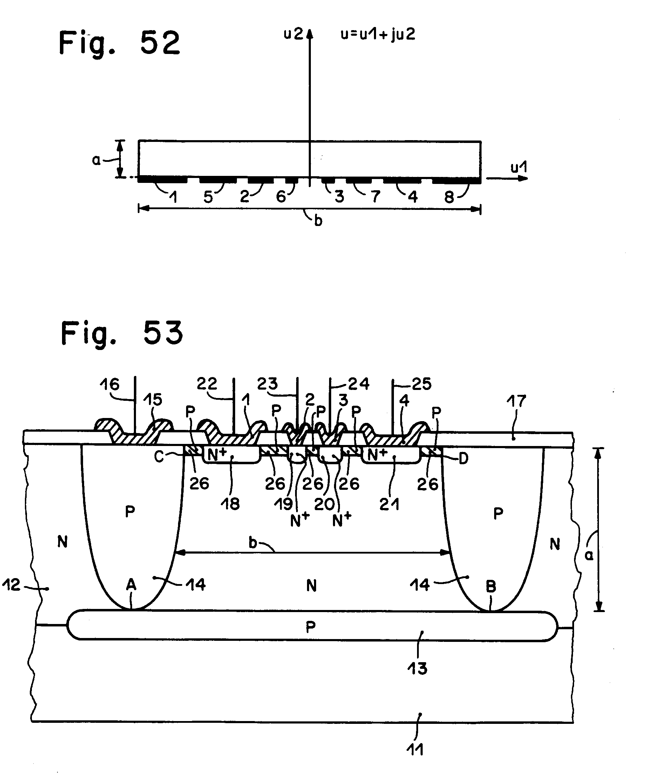

Vorzugsweise sind vier Elektroden 1 bis 4, die dann eine einzige Vierergruppe 1; 2; 3; 4 bilden, oder acht Elektroden 1 bis 8 vorhanden, die dann zwei Vierergruppen 1; 2; 3; 4 und 5; 6; 7; 8 bilden. In den Figuren 1 bis 49 sowie in der Fig. 52 wurde das Vorhandensein von vier Elektroden und in den Figuren 50 bis 51 das Vorhandensein von acht Elektroden angenommen.

In den Figuren 1 bis 47, 52 und 53 ist jeweils eine Querschnittsebene des erfindungsgemässen Hallelementes dargestellt, die jeweils Querschnitte der vier Elektroden 1 bis 4 bzw. der acht Elektroden 1 bis 8 enthält. Das erfindungsgemässe Hallelement besitzt einen ebenen polygonalen Querschnitt 9, der in der genannten Querschnittsebene gelegen ist. In der Querschnittsebene sind auf den Seiten des Querschnittes 9 des Hallelementes Querschnitte der Elektroden 1 bis 4 bzw. der Elektroden 1 bis 8 angeordnet. Jede Querschnittsebene ist mit einer gedachten u1-Koordinatenachse und einer dazu senkrecht gedachten u2-Koordinatenachse versehen, deren Nullpunkte jeweils mit dem Mittelpunkt des Querschnittes 9 des Hallelementes übereinstimmen. Jeder Punkt des Umfangs des Querschnittes 9 des Hallelementes und jeder Punkt der Querschnitte der Elektroden 1 bis 4 bzw. 1 bis 8 besitzt somit in der Querschnittsebene einen komplexen Wert $u = u1 + j.u2$ seiner Koordinaten, wobei j die imaginäre Einheit darstellt. Aus Gründen der zeichnerischen Einfachheit sind die u1- und die u2-Koordinatenachsen nur in der Fig. 1 und in der Fig. 52 dargestellt.

Der polygone Querschnitt 9 ist in einer vorteilhaften Ausführung viereckförmig und dann wieder vorzugsweise rechteckförmig oder trapezförmig. In den Figuren 1 bis 47 sowie in der Fig. 52 wurde jeweils das Vorhandensein eines rechteckförmigen Querschnittes 9 angenommen. Die Figuren 1 bis 47 stellen dabei beim Vorhandensein von nur vier Elektroden eine nicht erschöpfende Liste von möglichen Anordnungen der Querschnitte der Elektroden 1 bis 4 in der Querschnittsebene dar.

In allen Varianten sind die Querschnitte aller Elektroden 1 bis 4 bzw. 1 bis 8 mathematisch konforme Abbildungen ("conformal mapping") einer aus einer ersten fiktiven Ebene in die Querschnittsebene transformierten ersten fiktiven Gruppe von nichtüberlappenden Querschnitten gleichvieler erster fiktiver Elektroden 1a bis 4a bzw. 1a bis 8a. Die fiktiven Elektroden 1a bis 4a bzw. 1a bis 8a sind dabei in der ersten fiktiven Ebene auf dem Umfang eines Kreises 10 punktsymmetrisch zum Zentrum des Kreises 10 angeordnet. Der Radius des Kreises 10 beträgt Eins. Zu jeder Viergruppe der Elektroden 1 bis 4 bzw. 1 bis 8 gehört in der ersten fiktiven Gruppe je eine Vierergruppe 1a; 2a; 3a; 4a bzw. 5a; 6a; 7a; 8a der ersten fiktiven Elektroden 1a bis 4a bzw. 1a bis 8a. Die erste fiktive Gruppe ist dann in einer Vierergruppe 1a; 2a; 3a; 4a bzw. in zwei Vierergruppen 1a; 2a; 3a; 4a und 5a; 6a; 7a; 8a unterteilt. Innerhalb einer jeden Vierergruppe 1a; 2a; 3a; 4a bzw. 5a; 6a; 7a; 8a besitzen die Querschnitte der zugehörigen ersten fiktiven Elektroden 1a bis 4a bzw. 5a bis 8a jeweils auf dem Umfang des Kreises 10 gleiche Abstände zueinander.

In der Fig. 48 ist für den Fall, dass nur vier Elektroden 1 bis 4 vorhanden sind, die zugehörige erste fiktive Ebene mit dem dazugehörigen Kreis 10 und den dazugehörigen ersten fiktiven Elektroden 1a bis 4a dargestellt. In der Fig. 51 ist desgleichen für den Fall, dass acht Elektroden 1 bis 8 vorhanden sind, die zugehörige erste Ebene mit dem dazugehörigen Kreis 10 und den dazugehörigen ersten fiktiven Elektroden 1a bis 8a dargestellt. In der Fig. 51 ist die Vierergruppe 5a; 6a; 7a; 8a um einen konstanten Winkel $\delta$ gegenüber der Vierergruppe 1a; 2a; 3a; 4a verdreht angeordnet. Einfachheitshalber wurde in den Figuren 48 und 51 angenommen, dass innerhalb einer jeden Vierergruppe die Querschnitte der Elektroden 1a bis 4a bzw. 5a bis 8a gleich gross sind.

Die erste fiktive Ebene besitzt jeweils eine gedachte w1-Koordinatenachse und eine dazu senkrecht gedachte w2-Koordinatenachse, deren Nullpunkte jeweils mit dem Zentrum des Kreises 10 übereinstimmen. Der Kreis 10 schneidet die w1-Koordinatenachse in den beiden Punkten $1+j.0$ und $-1+j.0$. Jeder Punkt des Kreises 10 besitzt einen komplexen Wert $w=w1+j.w2$ seiner Koordinaten w1, w2. Die Querschnitte der ersten fiktiven Elektroden 1a bis 4a bzw. 1a bis 8a sind jeweils Kreissegmente.

Bei einem rechteckförmigen Querschnitt 9 des Hallelementes entsprechen die in der Fig. 48 dargestellten ersten fiktiven Elektroden 1a bis 4a den vier in einer der Figuren 1 bis 47 dargestellten Elektroden 1 bis 4, d. h. die letzten sind in der Querschnittsebene einer der Figuren 1 bis 47 die mathematisch konformen Abbildungen der in der ersten fiktiven Ebene der Fig. 48 dargestellten ersten fiktiven Elektroden 1a bis 4a.

Desgleichen entsprechen bei einem rechteckförmigen Querschnitt 9 des Hallelementes die in der Fig. 51 dargestellten ersten fiktiven Elektroden 1a bis 8a den acht in der Figur 52 dargestellten Elektroden 1 bis 8, d. h. die letzten sind in der Querschnittsebene der Fig. 52 die mathematisch konformen Abbildungen der in der ersten fiktiven Ebene der Fig. 51 dargestellten ersten fiktiven Elektroden 1a bis 8a.

In den Figuren 1 bis 47 und in der Figur 52 sind die Querschnitte der Elektroden 1 bis 8 jeweils geradlinig, L-förmig oder U-förmig, je nachdem ob die betreffende Elektrode nur auf einer Seite, auf zwei Seiten um eine Kante herum oder auf drei Seiten um zwei Kanten herum auf dem Umfang des rechteckförmigen Querschnittes 9 angeordnet ist.

Nachfolgend gilt die Annahme des Vorhandenseins eines rechteckförmigen Querschnittes 9.

Statt die in der Fig. 48 dargestellten ersten fiktiven Elektroden 1a bis 4a direkt in der Querschnittsebene konform abzubilden, kann dies zur Vereinfachung der Rechnungen und des Verständnisses über eine oder zwei Zwischenstufen erfolgen:

- Im ersten Fall werden gemäss der Fig. 49 in einer zweiten fiktiven Ebene als eine zweite fiktive Gruppe gleichvieler zweiter fiktiver Elektroden 1b bis 4b die mathematisch konformen Abbildungen der in der ersten fiktiven Ebene dargestellten ersten fiktiven Elektroden 1a bis 4a dargestellt. In der zweiten fiktiven Ebene sind eine gedachte reelle z1-Koordinatenachse und eine dazu senkrecht gedachte z2-Koordinatenachse vorhanden, so dass die zweiten fiktiven Elektroden 1b bis 4b die komplexen Werte $z=z1+j.z2$ als Koordinaten besitzen. Der Kreis 10 der ersten fiktiven Ebene entspricht der reellen z1-Koordinatenachse in der zweiten fiktiven Ebene, so dass die Querschnitte der zweiten fiktiven Elektroden 1b bis 4b in der zweiten fiktiven Ebene geradlinig sind und ebenfalls auf der z1-Koordinatenachse liegen, und zwar auf diese symmetrisch zum Nullpunkt (siehe Fig. 49). Diese Symmetrie führt dazu, dass die Querschnitte der Elektroden 1 bis 4 in der Querschnittsebene achssymmetrisch zur Koordinatenachse u2 auf den rechteckförmigen Querschnitt 9 des Hallelementes angeordnet sind. Die Querschnitte der Elektroden 1 bis 4 in der Querschnittsebene sind ihrerseits die mathematisch konformen Abbildungen der in der zweiten fiktiven Ebene dargestellten Querschnitte der zweiten fiktiven Elektroden 1b bis 4b.

Es gelten folgende Gleichungen für die beiden konformen Abbildungen:

$$Y = -j\alpha(w+j)/(w-j) \qquad \text{(I) und}$$

$$u = \frac{b}{\displaystyle\int_0^1 \frac{2\,dx}{\sqrt{(1-x^2)(1-k^2x^2)}}} \int_0^Y \frac{dx}{\sqrt{(1-x^2)(1-k^2x^2)}} \qquad \text{(II)},$$

wobei $\alpha$ ein frei wählbarer reeller Parameter ist und der Wert von Y in der Gleichung II mittels der Gleichung I berechnet werden kann. Der Wert von k ist durch die Gleichung

$$\frac{\displaystyle\int_0^1 \frac{dx}{\sqrt{(1-x^2)(1-x^2+k^2x^2)}}}{\displaystyle\int_0^1 \frac{2\,dx}{\sqrt{(1-x^2)(1-k^2x^2)}}} = \frac{a}{b} \qquad \text{(III)}$$

gegeben. Der Buchstabe j stellt dabei die imaginäre Einheit dar, während a und b die Werte der Seitenlängen des rechteckförmigen Querschnittes (9) bezeichnen. Der Parameter w bezeichnet die komplexen Werte w1 + j.w2 der Koordinaten der Endpunkte der Querschnitte der ersten fiktiven Elektroden 1a bis 4a in der ersten fiktiven Ebene. Der Parameter z stellt dagegen die komplexen Werte z1 + j.z2 der Koordinaten der Endpunkte der Querschnitte der zweiten fiktiven Elektroden 1b bis 4b in der zweiten fiktiven Ebene dar. Der Parameter u bezeichnet die komplexen Werte u1 + j.u2 der Koordinaten der Endpunkte der Querschnitte der Elektroden 1 bis 4 in der Querschnittsebene. Der Buchstabe x stellt seinerseits eine Variable dar.

Durch Eliminierung von Y aus den Gleichungen I und II entsteht die Gleichung:

$$u = \frac{b}{\displaystyle\int_0^1 \frac{2\,dx}{\sqrt{(1-x^2)(1-k^2x^2)}}} \int_0^{-j\alpha(w+j)/(w-j)} \frac{dx}{\sqrt{(1-x^2)(1-k^2x^2)}} \qquad \text{(IV)}.$$

Die zur u2-Koordinatenachse symmetrische Anordnung der Querschnitte der Elektroden 1 bis 4 in der Querschnittsebene wird durch die zweite Zwischenstufe der nachfolgend beschriebenen Methode vermieden.

- Im zweiten Fall existiert noch eine dritte fiktive Ebene, in der eine gedachte reelle v1-Koordinatenachse und eine dazu senkrecht gedachte v2-Koordinatenachse gemäss der Fig. 50 vorhanden sind. Dabei

4

ist die v2-Koordinatenachse um einen konstanten Wert eines reellen frei wählbaren Parameters $\beta$ gegenüber der parallelen z2-Koordinatenachse der zweiten fiktiven Ebene parallel verschoben, während die v1- und die z1-Koordinatenachsen übereinstimmen. Die in dieser dritten fiktiven Ebene angeordneten Querschnitte einer dritten fiktiven Gruppe von dritten fiktiven Elektroden 1c bis 4c sind mathematisch konforme Abbildungen der in der zweiten fiktiven Ebene dargestellten Querschnitte der zweiten fiktiven Elektroden 1b bis 4b. Die Querschnitte der dritten fiktiven Elektroden 1c bis 4c liegen in der dritten fiktiven Ebene alle auf der reellen v1-Koordinatenache, jedoch unsymmetrisch zu deren Nullpunkt (siehe Fig. 50). Diese Unsymmetrie hat zur Folge, dass auch die Querschnitte der Elektroden 1 bis 4 in der Querschnittsebene nicht mehr symmetrisch zur u2-Koordinatenachse angeordnet sind. Die Querschnitte der Elektroden 1 bis 4 in der Querschnittsebene sind ihrerseits die mathematisch konformen Abbildungen der in der dritten fiktiven Ebene dargestellten Querschnitte der dritten fiktiven Elektroden 1c bis 4c.

Zusätzlich zu den Gleichungen I bis III gilt hier noch die Gleichung

$$v = z + \beta \qquad (V),$$

die in der Gleichung IV eingeführt, folgende Gleichung ergibt:

$$u = \frac{b}{\displaystyle\int_0^1 \frac{2dx}{\sqrt{(1-x^2)(1-k^2x^2)}}} \int_0^{-j\alpha(w+j)/(w-j)} \frac{dx}{\sqrt{[1-(x+\beta)^2][1-k^2(x+\beta)^2]}} \qquad (VI).$$

Die Gleichung IV ist dabei in der Gleichung VI enthalten, da sie einem Wert Null des Parameters $\beta$ entspricht.

Die drei fiktiven Ebenen mit den zugehörigen Querschnitten fiktiver Elektroden 1a bis 4a bzw. 1b bis 4b bzw. 1c bis 4c sind immer nur mathematisch gedachte Ebenen, die im Hallelement räumlich gar nicht vorhanden sind und die nur den Berechnungen dienen.

Ausgehend von gegebenen Werten a und b der Seitenlängen des rechteckförmigen Querschnittes 9, von frei gewählten reellen Werten der Parameter $\alpha$ und $\beta$ und von einem mittels der Gleichung III berechneten Wert von k, ergibt die Gleichung VI in den beiden Fällen in der Querschnittsebene die komplexen Werte $u1 + j.u2$ der Koordinaten u1, u2 eines jeden der beiden Endpunkte der Querschnitte der Elektroden 1 bis 4 bzw., wenn mehr als vier Elektroden vorhanden sind, der beiden Endpunkte der Querschnitte aller Elektroden 1 bis 8. Im vorteilhaften ersten Fall ist dabei der Wert des Parameters $\beta$ gleich Null zu wählen.

Die so berechneten Endpunkte der Querschnitte aller Elektroden 1 bis 4 bzw. 1 bis 8 sind in der Regel unregelmässig über die Umfangslänge des rechteckförmigen Querschnittes 9 verteilt, was bedeutet, dass sowohl die Längen der Querschnitte der einzelnen Elektroden 1 bis 4 bzw. 1 bis 8 als auch die Abstände zwischen zwei benachbarten Elektroden in der Regel sehr unterschiedlich sind. Anders ausgedrückt: Die Querschnitte der Elektroden 1 bis 4 bzw. 1 bis 8 sind in der Regel weit davon entfernt punktsymmetrisch zum Mittelpunkt des rechteckförmigen Querschnittes 9 angeordnet zu sein. Diese vollständige Unsymmetrie in der Elektrodenanordnung müsste eigentlich zu unsymmetrischen elektrischen Eigenschaften des Hallelementes und damit zu Nullspannungen des Hallelementes führen, die unterschiedlich von Null sind. Nur die Tatsache, dass die Endpunkte der Querschnitte der Elektroden 1 bis 4 bzw. 1 bis 8 mathematisch konforme Abbildungen sind der in der ersten fiktiven Ebene punktsymmetrisch zum Zentrum des Kreises 10 angeordneten Endpunkte der Querschnitte der ersten fiktiven Elektroden 1a bis 4a bzw. 1a bis 8a, halten deren symmetrische elektrische Eigenschaften während der mathematisch konformen Transformation aufrecht trotz resultierendem unsymmetrischem räumlichem Aufbau. Das resultierende Hallelement mit den in der Querschnittsebene punktunsymmetrisch angeordneten Querschnitte der Elektroden 1 bis 4 bzw. 1 bis 8 besitzt somit symmetrische elektrische Eigenschaften und seine Nullspannung ist demnach mindestens theoretisch gleich Null.

In vielen der so berechneten Lösungsvarianten sind die Querschnitte aller Elektroden 1 bis 4 bzw. 1 bis 8 auf einer einzigen Seite des Querschnittes 9 angeordnet (siehe Fig. 1, Fig. 16, Fig. 17, Fig. 19 und Fig.

52). Diese Lösungsvarianten eignen sich daher besonders gut zur Realisierung von integrierten Hallelementen, die z.B. in einer integrierten Schaltung integrierbar sind. In diesem Fall entspricht die Seite des Querschnittes 9, auf der die Querschnitte aller Elektroden 1 bis 4 bzw. 1 bis 8 angeordnet sind, der Oberfläche des integrierten Hallelementes und der integrierten Schaltung. Ein Querschnitt eines solchen integrierten Hallelementes ist in der Fig. 53 dargestellt. Das integrierte Hallelement besteht dann aus einem fakultativ vorhandenen Substrat 11, einer auf dem Substrat 11 aufgetragenen Halbleiterschicht 12, deren Dicke den Wert a besitzt, einer fakultativ vorhandenen vergrabenen Schicht ("burried layer") 13, die an der Grenzfläche und parallel zu dieser zwischen dem Substrat 11 und der Halbleiterschicht 12 angeordnet ist, und einer rechteckig ringförmigen Wanne ("well") 14, die an der Oberfläche der Halbleiterschicht 12 mit einem Anschlusskontakt 15 versehen ist, der z. B. einen Anschlussdraht 16 aufweist. Die Oberfläche der Halbleiterschicht 12 ist ausserdem mit einer Oxidschicht 17 bedeckt, die durch den Anschlusskontakt 15 und die vier Elektroden 1 bis 4 durchquert wird, wobei die vier Elektroden I bis 4 je mit einer Kontaktdiffusion 18 bzw. 19 bzw. 20 bzw. 21 und mit je einem Anschlussdraht 22 bzw. 23 bzw. 24 bzw. 25 versehen sind. Die Kontaktdiffusionen 18 bis 21 sind an der Oberfläche in die Halbleiterschicht 12 eindiffundiert und stark mit Fremdatomen dotiert. Sie sind ausserdem vom gleichen Materialleitfähigkeitstyp, z. B. vom Typ N, wie die Halbleiterschicht 12, während die vergrabene Schicht 13 und die Wanne 14 vom entgegengesetzten Materialleitfähigkeitstyp, also z. B. vom Typ P, sind. An der Oberfläche der Halbleiterschicht 12 und innerhalb der ringförmigen Wanne 14 ist noch eine dünne ("shallow") Schicht 26 Halbleitermaterial in die Halbleiterschicht 12 eindiffundiert, die vom gleichen Materialleitfähigkeitstyp, also z. B. vom Typ P, ist wie die vergrabene Schicht 13 und die Wanne 14 und die jeweils von den Kontaktdiffusionen 18 bis 21 durchquert wird.

Wenn das nur fakultativ vorhandene Substrat 11 und die nur fakultativ vorhandene vergrabene Schicht 13 fehlen, dann berührt die Wanne 14 nicht, wie in der Fig. 53 dargestellt, den Boden der Halbleiterschicht 12. Diese weist in diesem Fall einen bedeutend grösseren Wert für a auf.

Die Wanne 14 berührt in der Darstellung der Fig. 53 die vergrabene Schicht 13 in den Punkten A und B sowie die Oberfläche der Halbleiterschicht 12 unter anderem in den Punkten C und D. Die Fläche ABCD stellt den Querschnitt 9 des eigentlichen integrierten Hallelementes dar. Sie ist nach oben und unten durch zwei annähernd parallele Seiten AB und CD sowie seitlich durch zwei gekrümmte Seiten AC und DB begrenzt. Der Abstand zwischen den beiden parallelen Seiten AB und CD ist annähernd gleich dem Wert a der Dicke der Halbleiterschicht 12, da die Dicke der vergrabenen Schicht 13 relativ dünn ist. Der Abstand zwischen den gekrümmten Seiten AC und DB entspricht dem Wert b und ist im Gegensatz zu einem rechteckförmigen Querschnitt 9 nicht konstant. Da der Wert von a bei integrierten Hallelementen sehr klein ist, kann die Fläche ABCD des Querschnittes 9 in erster Annäherung als trapezförmig oder sogar als rechteckförmig angenommen werden, wobei im letzten Fall ein Mittelwert der Werte von b als geltender Wert für b angenommen werden muss.

Das Hallelement kann somit als integriertes Hallelement ausgebildet sein, wobei mindestens in erster Annäherung sein Querschnitt 9 als trapezförmig oder als rechteckförmig angenommen werden kann. Im letzten Fall sind die Gleichungen I bis VI verwendbar zur Berechnung der Endpunkte der Querschnitte der Elektroden 1 bis 4. Die so berechneten und gefundenen Koordinaten u1, u2 müssen dann anschliessend gegebenenfalls leicht korrigiert werden zur Berücksichtigung der nicht ideal rechteckförmigen Gestalt des Querschnittes 9 des integrierten Hallelementes.

Die Elektroden 1 bis 4 bzw. 1 bis 8 des integrierten Hallelementes liegen alle annähernd auf einer geraden Linie, aber sie sind im Gegensatz zur bekannten Anordnung der EP 0 148 330 A2 nicht alle gleichgross.

Obwohl die Nullspannung Uo des Hallelementes theoretisch gleich Null ist, wird in der Praxis durch Herstellungsunsymmetrien und/oder durch Rauschen immer ein kleiner von Null unterschiedlicher Restwert der Nullspannung Uo vorhanden sein. Dieser Restwert der Nullspannung Uo kann durch eine von mehreren an sich bekannten Methoden eliminiert werden, vorzugsweise jedoch durch die in der US-PS 4 037 150 beschriebene Methode.

In diesem Fall sind die Elektroden 1, 2, 3 und 4 bzw. die Elektrodenkombinationen 1; 5, 2; 6, 3; 7 und 4; 8 des Hallelementes mit einer Umschaltanordnung verbunden, die vier Anschlüsse zum Anschliessen der vier Elektroden 1 bis 4 bzw. der vier Elektrodenkombinationen 1;5 bis 4; 8, einen zweipoligen Spannungsausgang U1; U2, einen zweipoligen Stromeingang I1; I2 zum Anschliessen einer Stromquelle und einen Steuereingang aufweist. Der Steuereingang dient dabei dem Umschalten von Schaltern, die in der Umschaltanordnung enthalten sind. Durch die Umschaltanordnung werden die Elektroden 1 bis 4 bzw. die Elektrodenkombinationen 1; 5 bis 4; 8 des Hallelementes mit dem Spannungsausgang U1; U2 des Hallelementes und mit der Stromquelle verbunden. Dabei sind jeweils die acht folgenden verschiedenen Schaltstellungen E bis M möglich:

| Schaltstellungen | E | F | G | H | J | K | L | M |
|---|---|---|---|---|---|---|---|---|
| Elektrode 1 | I1 | U2 | I2 | U1 | U2 | I1 | U1 | I2 |
| Elektrode 2 | U1 | I1 | U2 | I2 | I2 | U2 | I1 | U1 |
| Elektrode 3 | I2 | U1 | I1 | U2 | U1 | I2 | U2 | I1 |
| Elektrode 4 | U2 | I2 | U1 | I1 | I1 | U1 | I2 | U2 |

Dabei bezeichnen I1 und I2 die beiden Pole des Stromeingangs I1; I2 und U1 und U2 die beiden Pole des Spannungsausgangs U1; U2 jeweils der Umschaltanordnung.

Eine Spannungsdifferenz U1(k)-U2(k) hängt ab von der Schaltstellung k der in der Umschaltanordnung enthaltenen Schalter und beträgt:

$$U1(k)-U2(k) = (-1)^k Uo + U_{Hall} \qquad \text{(VII) bei } k = 1, 2, 3 \text{ oder } 4, \text{ und}$$
$$U1(k)-U2(k) = (-1)^k Uo - U_{Hall} \qquad \text{(VIII) bei } k = 5, 6, 7 \text{ oder } 8,$$

wobei U1(k) und U2(k) die Spannungen an den beiden Polen der Ausgangsspannung U1; U2 der Umschaltanordnung bezeichnen und $U_{Hall}$ die Ausgangsspannung des Hallelementes ist.

Durch Messung der Spannungsdifferenz U1(k)-U2(k) in zwei beliebigen Schaltstellungen der Umschaltanordnung, bei denen die Nullspannung Uo und $U_{Hall}$ in den Gleichungen VII und VIII unterschiedliche Vorzeichen aufweisen, kann dann die Nullspannung Uo aus den beiden Gleichungen VII und VIII eliminiert und der Wert der Ausgangsspannung $U_{Hall}$ des Hallelementes bestimmt werden. Dabei kann das gewählte Paar Schaltstellungen beliebig aus allen möglich vorhandenen Paaren von Schaltstellungen ausgewählt werden. Die mittels der beiden Gleichungen VII und VIII gefundenen Messwerte sind dabei entweder zu addieren oder zu subtrahieren, um die Ausgangsspannung $U_{Hall}$ des Hallelementes zu erhalten.

## Patentansprüche

1.  Hallelement mit einem polygonalen ebenen Querschnitt (9) und mit in der Querschnittsebene auf Seiten des Querschnittes (9) angeordneten Querschnitten von Elektroden (1 bis 4, 1 bis 8), deren Anzahl ein Multipel von Vier ist, **dadurch gekennzeichnet**, daß die Querschnitte der Elektroden (1 bis 4, 1 bis 8) nicht punktsymmetrisch zum Mittelpunkt des polygonalen ebenen Querschnitts (9) angeordnet sind und daß die Querschnitte der Elektroden (1 bis 4, 1 bis 8) mathematisch konforme Abbildungen ("conformal mapping") einer aus einer fiktiven Ebene in die Querschnittsebene transformierten fiktiven Gruppe von nichtüberlappenden Querschnitten der gleichen Anzahl fiktiver Elektroden (1a bis 4a, 1a bis 8a) darstellen, die in der fiktiven Ebene auf dem Umfang eines Kreises (10), dessen Radius Eins beträgt, punktsymmetrisch zum Zentrum des Kreises (10) angeordnet sind, wobei die fiktive Gruppe in Vierergruppen (1a; 2a; 3a; 4a; und 5a; 6a; 7a; 8a) unterteilt ist, innerhalb derselben die Querschnitte der zugehörigen fiktiven Elektroden (1a bis 4a bzw. 5a bis 8a) jeweils auf dem Umfang des Kreises (10) gleiche Abstände zueinander besitzen.

2.  Hallelement nach Anspruch 1, in dem der polygone Querschnitt (9) viereckförmig ist.

3.  Hallelement nach Anspruch 2, dadurch gekennzeichnet, dass der Querschnitt (9) trapezförmig ist.

4.  Hallelement nach Anspruch 2 mit einem mindestens annähernd rechteckförmigen Querschnitt (9), dadurch gekennzeichnet, dass in der Querschnittsebene die Koordinaten (u1, u2) eines jeden der beiden Endpunkte der Querschnitte der Elektroden (1 bis 4, 1 bis 8) gegeben sind durch die komplexen Werte (u1 + j.u2) von

$$\cfrac{b}{\displaystyle\int_0^1 \frac{2dx}{\sqrt{(1-x^2)(1-k^2x^2)}}} \int_0^{-j\alpha(w+j)/(w-j)} \frac{dx}{\sqrt{[1-(x+\beta)^2][1-k^2(x+\beta)^2]}} \quad ,$$

wobei $\alpha$ und $\beta$ zwei frei wählbare reelle Parameter sind, der Wert von k durch die Gleichung

$$\cfrac{\displaystyle\int_0^1 \frac{dx}{\sqrt{(1-x^2)(1-x^2+k^2x^2)}}}{\displaystyle\int_0^1 \frac{2dx}{\sqrt{(1-x^2)(1-k^2x^2)}}} = \frac{a}{b}$$

gegeben ist, j die imaginäre Einheit darstellt, a und b die Werte der Seitenlängen des rechteckförmigen Querschnittes (9) bezeichnen, w die komplexen Werte (w1 + j.w2) der Koordinaten (w1, w2) der Endpunkte der Querschnitte der fiktiven Elektroden (1a bis 4a, 1a bis 8a) in der fiktiven Ebene sind und x eine Variable darstellt.

5. Hallelement nach Anspruch 4, dadurch gekennzeichnet, dass der Parameter $\beta$ einen Wert Null besitzt.

6. Hallelement nach Anspruch 4 oder 5, dadurch gekennzeichnet, dass der Querschnitt (9) eines integrierten Hallelementes in erster Annäherung als rechteckförmig angenommen ist.

7. Hallelement nach Anspruch 6, dadurch gekennzeichnet, dass mindestens die berechneten Werte der Koordinaten (u1, u2) anschliessend leicht korrigiert worden sind zur Berücksichtigung der nicht ideal rechteckförmigen Gestalt des Querschnittes (9) des integrierten Hallelementes.

8. Hallelement mit vier Elektroden (1 bis 4) nach einem der Ansprüche 1 bis 7, dadurch gekennzeichnet, dass die vier Elektroden (1 bis 4) eine einzige Vierergruppe (1; 2; 3; 4) bilden, zu der eine Vierergruppe (1a; 2a; 3a; 4a) fiktiver Elektroden (1a, 2a, 3a, 4a) gehört.

9. Hallelement nach einem der Ansprüche 1 bis 7, dadurch gekennzeichnet, dass acht Elektroden (1 bis 8) vorhanden sind, die zwei Vierergruppen (1; 2; 3; 4 und 5; 6; 7; 8) bilden, zu denen je eine Vierergruppe (1a; 2a; 3a; 4a bzw. 5a; 6a; 7a; 8a) fiktiver Elektroden (1a, 2a, 3a, 4a bzw. 5a, 6a, 7a, 8a) gehört.

10. Hallelement nach einem der Ansprüche 1 bis 9, dadurch gekennzeichnet, dass das Hallelement an einer Schalter enthaltenden Umschaltanordnung angeschlossen ist, die einen Stromeingang (I1; I2) zum Anschliessen einer Stromquelle und einen Spannungsausgang (U1; U2) aufweist, und dass die Spannungen [U1(k), U2(k)] der beiden Pole (U1, U2) des Spannungsausganges U1; U2) der Umschaltanordnung in zwei Schaltstellungen der Schalter der Umschaltanordnung gemessen werden zur Eliminierung eines Restwertes einer Nullspannung (Uo).

**Claims**

1. A Hall element with a polygonal plane cross-section (9) and with cross-sections, which are arranged in the cross-sectional plane on sides of the cross-section (9), of electrodes (1 to 4, 1 to 8) whose number is a multiple of four, characterised in that the cross-sections of the electrodes (1 to 4, 1 to 8) are not arranged in point symmetrical relationship with the centre point of the polygonal plane cross-section (9), and that the cross-sections of the electrodes (1 to 4, 1 to 8) represent mathematically conformal mapping of a notional group, which is transformed out of a notional plane into the cross-sectional plane, of non-overlapping cross-sections of the same number of notional electrodes (1a to 4a, 1a to 8a) which are arranged in the notional plane on the circumference of a circle (10) whose radius is one in point symmetrical relationship with the centre of the circle (10), wherein the notional group is subdivided into groups of four (1a; 2a; 3a; 4a; and 5a; 6a; 7a; 8a), within which the cross-sections of the associated notional electrodes (1a to 4a and 5a to 8a) are respectively at equal spacings relative to each other on the circumference of the circle (10).

2. A Hall element according to claim 1 in which the polygonal cross-section (9) is quadrangular.

3. A Hall element according to claim 2 characterised in that the cross-section (9) is trapezoidal.

4. A Hall element according to claim 2 with an at least approximately rectangular cross-section (9) characterised in that in the cross-sectional plane the co-ordinates (u1, u2) of each one of the two end points of the cross-sections of the electrodes (1 to 4, 1 to 8) are given by the complex values (u1 + j.u2) of

$$\frac{b}{\displaystyle\int_0^1 \frac{2dx}{\sqrt{(1-x^2)(1-k^2x^2)}}} \int_0^{-ja(w+j)/(w-j)} \frac{dx}{\sqrt{[1-(x+\beta)^2][1-k^2(x+\beta)^2]}} \quad ,$$

wnerein $\alpha$ and $\beta$ are two freely selectible real parameters, the value of k is given by the equation

$$\frac{\displaystyle\int_0^1 \frac{dx}{\sqrt{(1-x^2)(1-x^2+k^2x^2)}}}{\displaystyle\int_0^1 \frac{2dx}{\sqrt{(1-x^2)(1-k^2x^2)}}} = \frac{a}{b} \quad ,$$

j represents the imaginary unit, a and b are the values of the lengths of the sides of the rectangular cross-section (9), w is the complex values (w1 + j.w2) of the co-ordinates (w1, w2) of the end points of the cross-sections of the notional electrodes (1a to 4a, 1a to 8a) in the notional plane and x represents a variable.

5. A Hall element according to claim 4 characterised in that the parameter $\beta$ is of a value of zero.

6. A Hall element according to claim 4 or claim 5 characterised in that the cross-section (9) of an integrated Hall element is assumed in a first approximation to be rectangular.

7. A Hall element according to claim 6 characterised in that at least the calculated values of the co-ordinates (u1, u2) have been subsequently slightly corrected to take account of the non-ideally rectangular configuration of the cross-section (9) of the integrated Hall element.

8. A Hall element having four electrodes (1 to 4) according to one of claims 1 to 7 characterised in that the four electrodes (1 to 4) form a single group of four (1; 2; 3; 4) to which there belongs a four group (1a; 2a; 3a; 4a) of notional electrodes (1a, 2a, 3a, 4a).

9. A Hall element according to one of claims 1 to 7 characterised in that there are eight electrodes (1 to 8) which form two groups of four (1; 2; 3; 4 and 5; 6; 7; 8) to each of which there belongs a respective four group (1a; 2a; 3a; 4a and 5a; 6a; 7a; 8a respectively) of notional electrodes (1a, 2a, 3a, 4a and 5a, 6a, 7a and 8a respectively).

10. A Hall element according to one of claims 1 to 9 characterised in that the Hall element is connected to a change-over switching arrangement which includes switches and which has a current input (I1; I2) for the connection of a current source and a voltage output (U1; U2), and that the voltages [U1(k), U2(k)] of the two poles (U1, U2) of the voltage output (U1; U2) of the change-over switching arrangement are measured in two switching positions of the switches of the change-over switching arrangement for eliminating a residual value of an offset voltage (Uo).

**Revendications**

1. Élément de Hall possédant une section transversale plane polygonale (9) et des électrodes (1 à 4, 1 à 8), dont les sections transversales sont disposées dans le plan de coupe transversal, sur des côtés de la section transversale (9) et dont le nombre est un multiple de quatre, caractérisé en ce que les sections transversales des électrodes (1 à 4, 1 à 8) ne sont pas disposées symétriquement par rapport au centre de la section transversale plane polygonale (9), et que les sections transversales des électrodes (1 à 4, 1 à 8) représentent des images, conformes du point de vue mathématique ("conformol mapping"), d'un groupe fictif, transformé depuis un plan fictif dans le plan de coupe transversal, de sections transversales non en chevauchement du même nombre d'électrodes physiques (1a à 4a, 1a à 8a), qui sont disposées, dans le plan fictif, sur la circonférence d'un cercle (10), dont le rayon est égal à l'unité, et ce d'une manière symétrique par rapport au centre du cercle (10), le groupe fictif étant subdivisé en des quartets (1a;2a;3a;4a et 5a;6a;7a;8a), à l'intérieur desquels les sections transversales des électrodes fictives associées (1a à 4a et 5a à 8a) sont séparées respectivement par les mêmes distances sur la circonférence du cercle (10).

2. Élément de Hall selon la revendication 1, dans lequel la section transversale polygonale (9) possède la forme d'un quadrilatère.

3. Élément de Hall selon la revendication 2, caractérisé en ce que la section transversale (9) possède la forme d'un trapèze.

4. Élément de Hall selon la revendication 2, possédant une section transversale (9) au moins approximativement rectangulaire, caractérisé en ce que dans le plan de coupe transversal, les coordonnées (u1,u2) de chacun des deux points d'extrémité des sections transversales des électrodes (1 à 4, 1 à 8) sont définis par les valeurs complexes (u1 + j.u2) de

$$\frac{b}{\displaystyle\int_0^1 \frac{2dx}{\sqrt{(1-x^2)(1-k^2x^2)}}} \int_0^{-j\alpha(w+j)/(w-j)} \frac{dx}{\sqrt{[1-(x+\beta)^2][1-k^2(x+\beta)^2]}} \quad ,$$

$\alpha$ et $\beta$ étant deux paramètres réels pouvant être choisis librement, tandis que la valeur de k est définie par la relation

$$\frac{\displaystyle\int_0^1 \frac{dx}{\sqrt{(1-x^2)(1-x^2+k^2x^2)}}}{\displaystyle\int_0^1 \frac{2dx}{\sqrt{(1-x^2)(1-k^2x^2)}}} = \frac{a}{b}$$

j représente l'unité imaginaire, a et b désignent les valeurs des longueurs des côtés de la section transversale de forme rectangulaire (9), w désigne la valeur complexe (w1 + j.w2) des coordonnées (w1,w2) des points d'extrémité des sections transversales des électrodes fictives (1a à 4a, 1a à 8a) dans le plan fictif et x une variable.

5. Élément de Hall selon la revendication 4, caractérisé en ce que le paramètre $\beta$ possède une valeur nulle.

6. Élément de Hall selon la revendication 4 ou 5, caractérisé en ce que la section transversale (9) d'un élément de Hall intégré est supposée posséder, en première approximation, une forme rectangulaire.

7. Élément de Hall selon la revendication 6, caractérisé en ce qu'au moins les valeurs calculées des coordonnées (u1,u2) ont été ensuite légèrement corrigées pour tenir compte de la configuration non idéalement rectangulaire de la section transversale (9) de l'élément de Hall intégré.

8. Élément de Hall comportant quatre électrodes (1 à 4) selon l'une des revendications 1 à 7, caractérisé en ce que les quatre électrodes (1 à 4) forment un seul quartet (1;2;3;4), dont fait partie un quartet (1a;2a;3a; 4a) d'électrodes fictives (1a,2a,3a,4a).

9. Élément de Hall selon l'une des revendications 1 à 7, caractérisé en ce qu'il est prévu huit électrodes (1 à 8), qui forment deux quartets (1;2;3;4 et 5;6;7;8), dont chacun inclut respectivement un quartet (1a;2a;3a;4a ou 5a;6a;7a;8a) d'électrodes fictives (1a,2a,3a,4a ou 5a,6a,7a,8a).

10. Élément de Hall selon l'une des revendications 1 à 9, caractérisé en ce que l'élément de Hall est raccordé à un dispositif de commutation contenant des interrupteurs et qui possède une entrée de courant (I1;I2) pour le raccordement d'une source de courant à une tension d'alimentation (U1;U2), et que les tensions [U1(k), U2(k)] des deux pôles (U1,U2) de la sortie de tension (U1;U2) du dispositif de commutation sont mesurées pour deux positions de commutation des interrupteurs du dispositif de commutation pour l'élimination de la valeur résiduelle d'une tension nulle (Uo).

Fig. 1

$u = u1 + ju2$

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

Fig. 22

Fig. 23

Fig. 24

Fig. 25

Fig. 26

Fig. 27

Fig. 28

Fig. 29

Fig. 30

Fig. 31

Fig. 32

Fig. 33

Fig. 34

Fig. 35

Fig. 36

Fig. 37

Fig. 38

Fig. 39

Fig. 40

Fig. 41

Fig. 42

Fig. 43

Fig. 44

Fig. 45

Fig. 46

Fig. 47

Fig. 48

$w2$  $w = w1 + jw2$

Fig. 49

$z2$  $z = z1 + jz2$

Fig. 50

$v2$  $v = v1 + jv2$

Fig. 51

$w2$  $w = w1 + jw2$

15

## Fig. 52

## Fig. 53